# EUROPÄISCHE PATENTSCHRIFT

(11) **EP 3 266 222 B1**
(45) Veröffentlichungstag und Bekanntmachung des Hinweises auf die Patenterteilung: **04.11.2020**
(21) Anmeldenummer: 16711985.8
(22) Anmeldetag: 01.03.2016
(51) Int. Cl.: H04R 25/00, H03G 9/02

(54) **VORRICHTUNG UND VERFAHREN ZUM ANSTEUERN DER DYNAMIKKOMPRESSOREN EINER BINAURALEN HÖRHILFE**
DEVICE AND METHOD FOR DRIVING THE DYNAMIC COMPRESSORS OF A BINAURAL HEARING AID
DISPOSITIF ET PROCÉDÉ POUR L'EXCITATION DES COMPRESSEURS DYNAMIQUES D'UN APPAREIL AUDITIF BINAURAL

(30) Priorität: 04.03.2015 DE 102015203855
(43) Veröffentlichungstag der Anmeldung: 10.01.2018
(73) Patentinhaber: Fraunhofer-Gesellschaft zur Förderung der angewandten Forschung e.V., 80686 München (DE); Carl von Ossietzky Universität Oldenburg, 26129 Oldenburg (DE)
(72) Erfinder: OETTING, Dirk, 26209 Hastten (DE); HOHMANN, Volker, 26131 Oldenburg (DE); EWERT, Stephan D., 26131 Oldenburg (DE); APPELL, Jens Ekkehart, 26121 Oldenburg (DE)
(74) Vertreter: Zinkler, Franz
(86) Internationale Anmeldenummer: PCT/EP2016/054328
(87) Internationale Veröffentlichungsnummer: WO 2016/139205

(56) Entgegenhaltungen:
- US-A1- 2011 249 823
- DIRK OETTING ET AL: "Model-based loudness compensation for broad- and narrow-band signals", ISAAR 2013 - AUDITORY PLASTICITY LISTENING WITH THE BRAIN - PROGRAMME AND ABSTRACTS, 28. August 2013 (2013-08-28), - 30. August 2013 (2013-08-30), Seite 121, XP055276066, & Dirk Oetting ET AL: "Model-based loudness compensation for broad- and narrow-band signals" In: "Proceedings of ISAAR 2013: Auditory Plasticity - Listening with the Brain", 1. Januar 2014 (2014-01-01), XP55275554, ISBN: 978-87-9900-134-7 Seiten 365-372, in der Anmeldung erwähnt
- DIRK OETTING ET AL: "Spectral and binaural loudness summation for hearing-impaired listeners", HEARING RESEARCH, Bd. 335, 1. Mai 2016 (2016-05-01), Seiten 179-192, XP055275556, NL ISSN: 0378-5955, DOI: 10.1016/j.heares.2016.03.010
- MOORE BRIAN C J ET AL: "Measurement and modeling of binaural loudness summation for hearing-impaired listeners", THE JOURNAL OF THE ACOUSTICAL SOCIETY OF AMERICA, AMERICAN INSTITUTE OF PHYSICS FOR THE ACOUSTICAL SOCIETY OF AMERICA, NEW YORK, NY, US, Bd. 136, Nr. 2, 1. Januar 1901 (1901-01-01), Seiten 736-747, XP012188300, ISSN: 0001-4966, DOI: 10.1121/1.4889868 [gefunden am 1901-01-01]

## Beschreibung

Die vorliegende Erfindung bezieht sich auf die Audiosignalverarbeitung und insbesondere auf die Audiosignalverarbeitung in Verbindung mit Hörhilfen.

Bei der Anpassung von Hörgeräten spielt das individuelle Lautheitsempfinden eine entscheidende Rolle. Der Hörverlust wird typischerweise durch das Audiogramm beschrieben und beinhaltet die Pegel der gerade wahrnehmbaren Töne (Hörschwelle, engl. hearing threshold level, HTL) zwischen typischerweise 125 Hz und 8 kHz und die Pegel der Töne, die zu einem unangenehm hohen Lautheitseindruck führen (Unannehmlichkeitsschwelle, engl. uncomfortable loudness level, UCL). Töne mit einem niedrigen Pegel müssen für den Schwerhörenden verstärkt werden, damit diese wieder hörbar werden. Typischerweise findet man in Schwerhörenden aber ähnliche Pegel für die Unannehmlichkeitsschwelle wie bei Normalhörenden. Dieses Phänomen wird als Recruitment bezeichnet. Das bedeutet, dass die Verstärkung für Signale mit einem hohen Pegel deutlich reduziert werden muss, um diese nicht "zu laut" für den Schwerhörenden zu machen. Diese pegel- und frequenzabhängige Verstärkung wird in heutigen Hörgeräten durch Multiband-Dynamikkompressoren durchgeführt. Diese zerlegen das Eingangssignal in verschiedene Frequenzbänder, messen den aktuellen Pegel in jedem Frequenzband und können so die gewünschte Verstärkung berechnen und anwenden. Ein Ziel bei der Anpassung der Verstärkungswerte an das individuelle Gehör ist die weitgehende Normalisierung der Lautheitswahrnehmung. Allerdings führt eine schmalbandige Lautheitskompensation in jedem Frequenzkanal oft zu einer als zu hoch empfundenen Lautheit bei breitbandigen und breitbandigen beidohrigen Signalen. Hier gibt es also das technische Problem, dass man mit einem Multiband-Dynamikkompressor mit unabhängiger Verstärkungsregelung in den Frequenzbändern keinen Lautheitsausgleich für schmal- und breitbandige Signale erreichen kann, da eine weitere Unterscheidung des Signaltyps vorgenommen werden muss, um die korrekten Verstärkungswerte anzuwenden. Über die Relevanz dieses Problems gibt es unterschiedliche Meinungen, die sich auf verschiedenen Studien stützen. Jedoch gibt es signifikante empirische Hinweise darauf, dass aktuelle Hörgeräteanpassungen in alltäglichen Hörsituationen als zu laut bei hohen Umgebungspegeln empfunden werden. Die vorliegende Erfindung zielt darauf ab, dieses spezifische Problem auf praktisch anwendbare Weise zu lösen.

Die Anpassung eines Multiband-Dynamikkompressors an den individuellen Hörverlust erfolgt heutzutage typischerweise auf Grundlage einer präskriptiven Anpassformel, die das Audiogramm als Eingabeparameter erhält. Lautheitsbasierenden Verfahren erhöhen den Messaufwand für die Erstanpassung, da zusätzlich zum Audiogramm eine Lautheitsskalierung durchgeführt werden muss. Bisher konnten sich lautheitsbasierte Verfahren nicht gegenüber schwellenbasierten präskriptiven Anpassungen im klinischen Alltag durchsetzen, da der messbare Vorteil in der Anpassung gering ausfällt und dadurch keine Zeit bei der Feinanpassung eingespart wird. Der heutige Standard, um Hörgeräte anzupassen, sind Audiogramm-basierte Vorschriften wie etwa NAL-NL2, DSL[i/o] oder herstellerspezifische Anpassregeln wie ConexxFit von Siemens. Diese schwellenbasierten Anpassregeln sind typischerweise auf die Optimierung der Sprachverständlichkeit und die Wiederherstellung der Lautheit von breitbandigen Signalen ausgelegt (NAL-NL1 Sprachsignal) und beinhalten zusätzlich auch noch empirische Korrekturfaktoren (NAL-NL2 Verstärkungsreduktion, da NAL-NL1 tendenziell als zu laut bewertet wurde). Bei den lautheitsausgleichenden Verfahren wurde entweder versucht, die schmalbandigen Lautheitsfunktionen wiederherzustellen oder die Lautheit von Sprache zu normalisieren. Nach der Erstanpassung erfolgt dann die Feinanpassung durch den Hörgeräteakustiker, um das Gerät auf das individuelle Lautheitsempfinden und die subjektive Präferenz, typischerweise für breitbandige Signale, einzustellen. Ein möglicher Algorithmus, der die Bandbreite bzw. den Pegel eines Signals ausnutzt, um unterschiedliche Verstärkungswerte für schmal- und breitbandige Signale anzuwenden, wird in [2] beschrieben. Die Frage bleibt, wie ein Algorithmus für unterschiedliche Signaltypen (z.B. schmal- und breitbandig) eingestellt werden kann. Eine mögliche Lösung ist die Verwendung von Lautheitsmodellen zur signalabhängigen Regelung der Verstärkung in Multiband-Dynamikkompressoren, wie es z.B. in [2] beschrieben wird. Ein Nachteil bei der Verwendung eines generalisierten Lautheitsmodells, sind die nicht unerheblichen Schätzfehler bei der individuellen Lautheitsbewertung von schmal- und breitbandigen Signalen, insbesondere in der versorgten Kondition.

Insbesondere nachteilig an Hörgeräte-Einstellungen ist, dass diese nicht für alle Situationen geeignet sind. Ein Grund hierfür ist, dass Einstellungen typischerweise für monaurale Signale gemacht werden. In anderen Worten bedeutet dies, dass ein Dynamikkompressor innerhalb eines Hörgeräts für das Individuum, das das Hörgerät nutzen wird, zunächst z.B. für das linke Ohr und dann für das rechte Ohr eingestellt wird. Selbst wenn die Einstellungen so vorgenommen werden, dass sie für schmalbandige und breitbandige Signale gleichermaßen passen, hat sich dennoch herausgestellt, dass diese Einstellungen z.B. für binaurale Signaltypen immer noch zu laut sind. Reduziert man dagegen die Verstärkungswerte, um für solche Signale womöglich eine angenehme Lautheit zu erreich, wären andere Signale wieder zu leise.

Daraus ergibt sich die Problematik, dass die Hörgeräte-Anpassung zwar für bestimmte Signaltypen relativ gut funktioniert, jedoch für andere Signaltypen wiederum nicht passend ist, was aufgrund der Nichtlinearität des menschlichen Hörens einerseits und aufgrund der vielen verschiedenen unterschiedlichen Hörschädigungen andererseits der Fall ist.

Die US 2011/249823 offenbart eine auf die von einem binauralen Hörhilfesystem empfangenen akustischen Signale angewendete Pegelkomprimierung. Diese wirkt der Beibehaltung von Inter-Aural Level Differences (ILD) entgegen und verringert dadurch die Fähigkeit des Benutzers, die Schallquelle zu lokalisieren, und folglich seine Fähigkeit für Sprachverstehen in lauten Umgebungen. Es ist daher bekannt, die Verstärkung in dem Hörgerät, das das lautere Signal empfängt, zu erhöhen und / oder die Verstärkung in dem Hörgerät, das das leisere Signal empfängt, zu verringern, was zumindest teilweise die Erhaltung der ILDs ermöglicht. In einigen Situationen verringert dies jedoch stattdessen die Fähigkeit des Benutzers, Sprache zu verstehen, z. B. wenn ein akustisches Geräusch an einem Ohr mit einem höheren Pegel als gleichzeitiges Sprechen am anderen Ohr empfangen wird. Dieses Problem wird überwunden, indem die Verstärkung in dem Hörgerät verringert wird, das das lautere Signal empfängt, und / oder die Verstärkung in dem Hörgerät erhöht wird, das das leisere Signal empfängt, wenn die Differenz zwischen den Geräuschpegeln der beiden Hörgeräte ansteigt.

Die Aufgabe der vorliegenden Erfindung besteht darin, ein verbessertes Konzept zum Ansteuern eines Dynamikkompressors zu schaffen. Diese Aufgabe wird durch eine Vorrichtung zum Ansteuern eines Dynamikkompressors nach Patentanspruch 1, ein Verfahren zum Ansteuern eines Dynamikkompressors nach Patentanspruch 11 oder ein Computer-Programm nach Patentanspruch 12 gelöst.

Eine Vorrichtung zum Ansteuern eines Dynamikkompressors einer Hörhilfe umfasst einen Kombinationssignalanalysator zum Feststellen einer Ähnlichkeit zwischen dem linken und rechten Audiosignal um eine binaurale Ähnlichkeit zu erhalten. Ferner ist ein Verstärkungseinsteller vorgesehen, um einen Verstärkungswert für ein Band des linken oder rechten Audiosignals in Abhängigkeit von der binauralen Ähnlichkeit und einem Pegel des linken oder rechten Audiosignals in dem Band zu schaffen.

Der Kombinationssignalanalysator arbeitet als Analysator, um den linken und rechten Kanal tatsächlich hinsichtlich seiner Binauralität zu analysieren.

Der Verstärkungseinsteller ist ausgebildet, um die binaurale Lautheitssummation zu berücksichtigen. So hat sich herausgestellt, dass eine Anpassung von Hörhilfen auf der Basis von schmalbandigen monauralen Testsignalen insbesondere für breitbandige Signale mit einem hohen Pegel zu einem zu lauten und daher nicht tolerablen Lautheitsempfinden des Individuums, das die Hörhilfe trägt, führt. In anderen Worten ausgedrückt, empfindet ein Individuum breitbandige binaurale Signale als zu laut. Wird dagegen eine Anpassung so vorgenommen, dass breitbandige binaurale Signale zur Anpassung verwendet werden, so sind monaurale Signale, wie sie beispielsweise beim Telefonieren vorhanden sind, für das Individuum zu leise.

Darüber hinaus hat sich herausgestellt, dass dieser Effekt der binauralen Lautheitssummation insbesondere bei breitbandigen Signalen, wie sie beispielsweise Sprachsignale sind, und darüber hinaus bei Signalen mit mittleren bis hohen Pegeln in den relevanten Bändern besonders zutage tritt. Andererseits ist bei schmalbandigen Signalen und/oder bei Signalen mit mittleren oder kleineren Pegeln der Effekt nicht stark ausgeprägt, so dass hier zwischen der binauralen und der monauralen Einstellung ein kleinerer Unterschied ist, dass also die Einstellung für monaurale Signale oder binaurale Signale jeweils relativ gut für die andere Klasse von Signalen passt.

Ein Ausführungsbeispiel betrifft einen Multiband-Dynamikkompressor bzw. eine Einstellung desselben dahin gehend, dass die Verstärkung in jedem Frequenzband durch einen oder mehrere Regelungsparameter gesteuert werden kann, die durch Analyse des Eingangssignals und deren Einordung in unterschiedliche Signalklassen parametriert werden. Die Binauralität des Audiosignals ermittelt und die Verstärkungswerte für die einzelnen Bänder werden basierend auf der Binauralität des Signals durchgeführt. Weitere Regelungsparameter sind die Bandbreite eines Signals, also z.B. das Verhältnis zwischen der Gesamtenergie zur jeweiligen Bandenergie, das Verhältnis zwischen Signal und Maskierungspegel der benachbarten Bänder, die Anzahl der nicht-maskierten Bänder, die Breite der Verteilung der Signalenergie in auditorischen Bändern etc., die zusätzlich zur Binauralität des Signals (monaural: nur auf einem Ohr; binaural: auf beiden Ohren das gleiche Signal) verwendet wird. Bei einem Beispiel, das nicht Teil der beanspruchten Erfindung ist, wird die Verstärkung im Multibandkompressor zuerst für die erste Signalklasse eingestellt, beispielsweise für monaurale Signale, und die Lautheitswahrnehmung wird nun mit diesen Einstellungen für die andere Signalklasse, also z.B. für binaurale Signale gemessen, und die Ergebnisse werden als Korrekturparameter oder Modifikationsparameter im Algorithmus angewendet, damit eine vorgegebene Lautheitszielfunktion erreicht wird. Ein so angepasster Algorithmus führt zu einem Lautheitsausgleich für beide Signalklassen und in Fortsetzung zu einer Anpassung für weitere gewünschte Signalklassen.

Bevorzugte Ausführungsbeispiele der vorliegenden Erfindung führen zu einer effizienteren und besseren Verstärkungsanpassung eines Kompressors zur Kompensation der veränderten Lautheitswahrnehmung bei Schwerhörenden für schmalbandige und breitbandige Signale durch eine direkte Messung der Versorgung der breitbandigen Lautheitswahrnehmung, insbesondere für binaurale Signale.

Beim Tragen einer so eingestellten Hörhilfe bzw. eines so eingestellten Hörgeräts werden leise schmalbandige Signale, z.B. der Signalton einer Waschmaschine, ausreichend laut wahrgenommen, aber auch laute breitbandige Signale, wie beispielsweise der Verkehrslärm, also binaurale breitbandige Signale, werden nicht als zu laut wahrgenommen.

Darüber hinaus kann der Aufwand für eine Anpassung reduziert werden, so dass trotz erhöhtem diagnostischen Aufwand für die Durchführung der Lautheitsskalierung insgesamt ein Zeitvorteil verbleibt.

Bevorzugte Ausführungsbeispiele der vorliegenden Erfindung werden nachfolgend Bezug nehmend auf die beiliegenden Zeichnungen detailliert erläutert. Es zeigen:
- Fig. 1: ein Blockschaltbild einer Vorrichtung zum Ansteuern eines Dynamikkompressors;
- Fig. 2: eine schematische Darstellung einer Kanalverstärkungsfunktion, die basierend auf der binauralen Ähnlichkeit, dem Kanalpegel und der Bandbreite eine Kanalverstärkung liefert;
- Fig. 3: eine weitere Darstellung einer Kanalverstärkungsfunktion mit einer festen Kanalverstärkungsfunktion und einer parameterabhängigen Pegelvariation;
- Fig. 4: ein Blockschaltbild eines Binauralprozessors mit einem Signalklassifizierer und einem nachgeschalteten Verstärkungseinsteller bzw. Kanalverstärkungsfunktionsberechner;
- Fig. 5: eine schematische Darstellung einer Hörhilfe mit Mikrofon, Audioprozessor, Multiband-Dynamikkompressor und Schallerzeuger;
- Fig. 6: eine schematische Darstellung von zwei Hörhilfen für den linken und rechten Kanal;
- Fig. 7: ein Flussdiagramm zur Darstellung eines Verfahrens zum Ermitteln von Verstärkungswerten für einen Dynamikkompressor;
- Fig. 8: eine Implementierung in Verbindung mit der Einstellung der Verstärkungswerte für einen Dynamikkompressor von Fig. 7;
- Fig. 9a: eine Darstellung des Hörvermögens von Normalhörenden im Vergleich zu Hörgeschädigten;
- Fig. 9b: Hörkurven für auf monaurale schmalbandige Signale angepasste Hörhilfen und monaurale Testsignale;
- Fig. 9c: Hörkurven für auf monaurale schmalbandige Signale angepasste Hörhilfen und binaurale Testsignale;

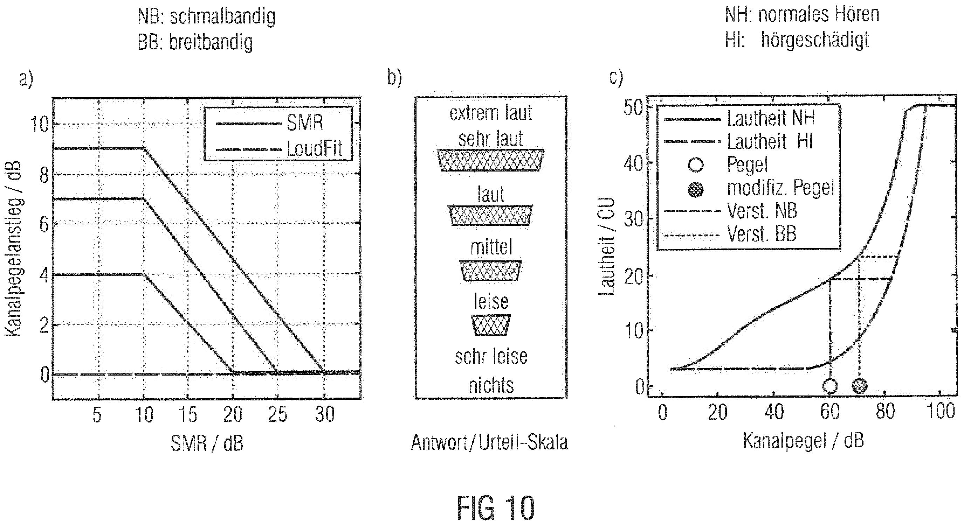

- Fig. 10: eine Darstellung der Kanalpegelanstiege, um eine optimale Anpassung für schmalbandige und breitbandige Signale zu erhalten; und
- Fig. 11: eine Übersicht über Bark-Spektren verschiedener Testsignale, d.h. eines schmalbandigen und verschiedener breitbandiger Testsignale.

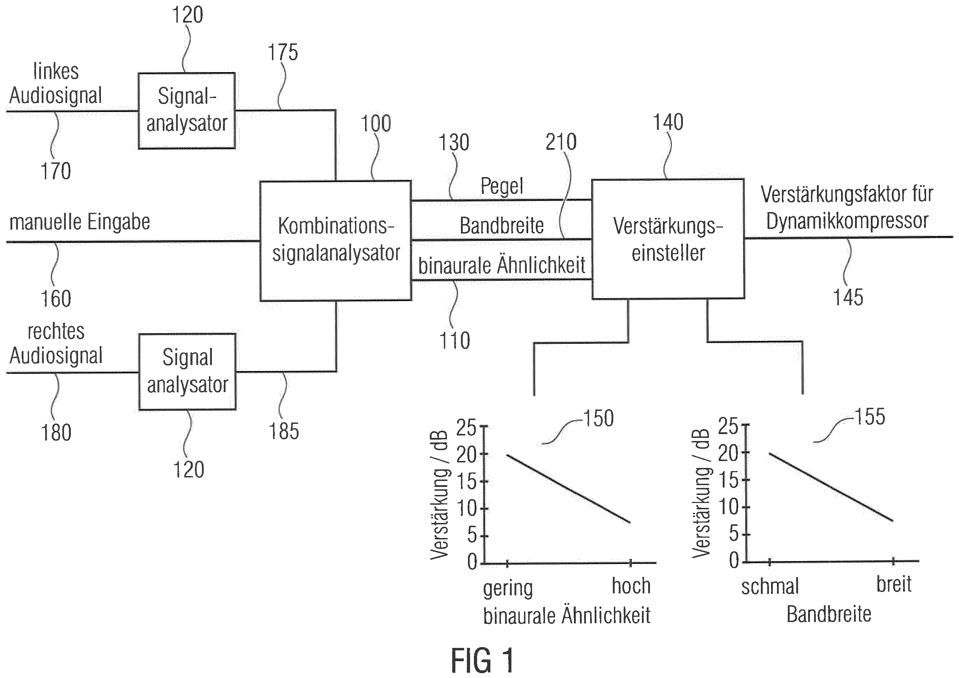

Fig. 1 zeigt ein Blockschaltbild einer Vorrichtung zum Ansteuern eines Dynamikkompressors, der in Fig. 1 nicht gezeigt ist, der jedoch Verstärkungsfaktoren 145 vom Ausgang eines Verstärkungseinstellers 140 erhält. Die Vorrichtung zum Ansteuern des Dynamickompressors, der typischerweise in einer Hörhilfe angeordnet ist, umfasst einen Kombinationssignalanalysator 100 zum Feststellen einer Ähnlichkeit des linken Audiosignals 170 mit dem rechten Audiosignal 180, um eine binaurale Ähnlichkeit 110 zu erhalten. Die binaurale Ähnlichkeit 110 wird in den Verstärkungseinsteller eingespeist, um einen Verstärkungswert für das linke oder das rechte Audiosignals in Abhängigkeit von der binauralen Ähnlichkeit 110 zu liefern. Ferner hängt der Verstärkungswert von einem Pegel 130 des linken oder rechten Audiosignals ab, wobei der Pegel 130 durch einen Signalanalysator 120 geliefert wird, der das linke Audiosignal 170 und/oder das rechte Audiosignal 180 erhält, um das Pegelergebnis 130 zu liefern. Alternativ kann der Pegel auch vom Kombinationssignalanalysator 100 geliefert werden, der als Eingangsparameter Signaleigenschaften des linken (175) und rechten (185) Audiosignals erhält, wie es in Fig. 1 gezeigt ist.

Der Verstärkungseinsteller 140 ist ausgebildet, um einen kleineren Verstärkungsfaktor 145 für das Audiosignal bei einer hohen binauralen Ähnlichkeit 110 zu liefern im Vergleich zu dem Verstärkungsfaktor, der für eine niedrige binaurale Ähnlichkeit 110 geliefert wird bei dem gleichen Pegel 130.

Dies bedeutet, dass bei gleichem Pegel für binaurale Signale ein kleinerer Verstärkungswert genommen wird als für nicht-binaurale bzw. monaurale Signale. Dies ist in dem Diagramm 150 zusammengefasst, dahin gehend, dass für Signale, die den gleichen Pegel haben, bei einer hohen binauralen Ähnlichkeit 110 ein vergleichsweise kleiner Verstärkungswert durch den Verstärkungseinsteller 140 geliefert wird, während für den gleichen Pegel bei geringer binauraler Ähnlichkeit ein größerer Verstärkungsfaktor genommen wird.

Zur Pegelmessung umfasst der Signalanalysator 120 eine Filterbank, wie beispielsweise eine FFT-Filterbank mit gleichen Bandbreiten oder eine gehörrichtige Filterbank, also z. B. eine Bark-Filterbank, bei der die Bänder zu höheren Frequenzen hin breiter werden. Diese Filterbank wird verwendet, um das linke und rechte Audiosignal in eine Mehrzahl von Bändern zu zerlegen, und um in jedem Band den entsprechenden Pegel zu ermitteln. Diese Pegel werden als Signaleigenschaft für das linke Signal 175 und das rechte Signal 185 an den Kombinationssignalanalysator 100 übertragen. Weitere Signaleigenschaften, die mit Hilfe des Signalanalysator 120 ermittelt werden können, sind unter anderem die Bandbreite des Signals, der Signalpegel, eine Beschreibung der spektralen Verteilung und das Zeitverhalten der Pegeländerung, Durch die Signaleigenschaften soll das Eingangssignal möglichst präzise beschrieben werden können, um im Kombinationssignalanalysator 100 die für einen Lautheitsausgleich wesentlichen Signalparameter berechnen zu können und damit die notwendigen Verstärkungsfaktoren 145 durch den Verstärkungseinsteller 140 zu ermitteln. Bei einer Versorgung mit Hörhilfen erfolgt die Übertragung der Signaleigenschaften vom linken Gerät über eine Drahtlos-Schnittstelle zum rechten Geräte. Eine Übertragung des gesamten Eingangssignals würde eine hohe Datenrate und damit einem hohen Stromverbrauch mit sich führen, der hier zu vermeiden ist. Somit müssen nur benötigte Signaleigenschaften, die das Signal beschreiben, bei einer geringen Datenrate übertragen werden. Bei einer Implementierung in einen Kopfhörer, bei dem eine verdrahtete Schnittstelle zwischen dem rechten und linken Kanals besteht, kann der Signalanalysator auch das Eingangssignal an den Kombinationssignalanalysator unverändert weiterleiten, so dass die gesamte Analyse des rechten und linken Kanals hinsichtlich der Pegel 130, der Bandbreite 210 und der binauralen Ähnlichkeit 110 im Kombinationssignalanalysator 100 stattfindet.

Ferner ist der Kombinationssignalanalysator bei einem Ausführungsbeispiel als tatsächlicher Kombinationssignalanalysator ausgebildet, um das linke und rechte Audiosignal im Hinblick auf die Bandbreite zu analysieren, wobei der Verstärkungseinsteller ausgebildet ist, um den Verstärkungsfaktor für das Band in Abhängigkeit von einer Schmalbandigkeit oder Breitbandigkeit des linken oder rechten Audiosignal einzustellen.

Bei einem bevorzugten Ausführungsbeispiel wird bei gleicher binauraler Ähnlichkeit und gleichem Pegel ein niedrigerer Verstärkungswert 145 für ein breitbandiges Signal verwendet als für ein schmalbandiges Signal 155. Dies berücksichtigt die Situation, dass die binaurale Lautheitssummation, insbesondere bei breitbandigen Signalen und nicht so sehr bei schmalbandigen Signalen bei Schwerhörenden erhöht ist, und daher eine Fehlsituation insbesondere bei einer schmalbandigen Anpassung der Hörhilfe und breitbandigen Signalen im realen Leben außerhalb der Testsituation stattfindet.

An dieser Stelle sei darauf hingewiesen, dass ein Verstärkungswert tatsächlich eine positive Verstärkung oder aber auch eine negative Verstärkung, also eine Dämpfung betreffen kann. Ist ein Verstärkungswert beispielsweise ein Verstärkungsfaktor, so liefert ein Verstärkungsfaktor größer als 1 eine tatsächliche Verstärkung, während ein Verstärkungsfaktor kleiner als 1 eine entsprechende Dämpfung, also eine negative Verstärkung liefert.

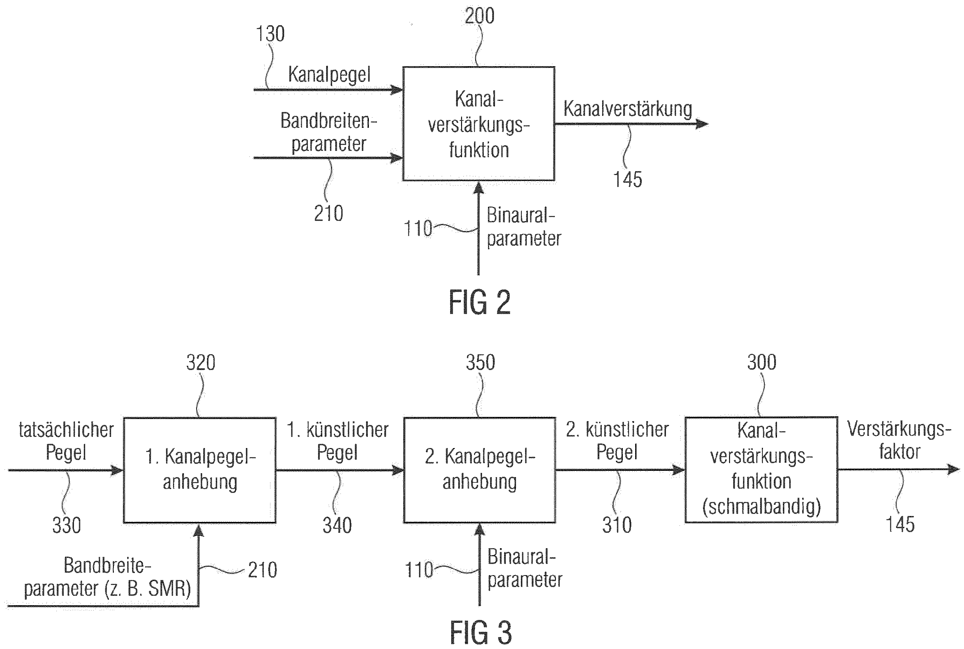

Fig. 2 zeigt eine alternative Darstellung des Verstärkungseinstellers, der eine Kanalverstärkungsfunktion 200 implementiert, die abhängig von dem Kanalpegel 130, von der Bandbreite 210 und der binauralen Ähnlichkeit 110 eine entsprechende Kanalverstärkung 145 liefert. Die Kanalverstärkungsfunktion kann als Tabelle oder als arithmetische Funktion oder als eine Kombination von beiden implementiert sein. Insbesondere könnte eine Tabellenimplementierung darin bestehen, dass als Eingangsparameter der Kanalpegel 130 und als Ausgangsparameter die Kanalverstärkung 145 verwendet wird. Eine Bandbreite würde dann genauso wie eine binauralen Ähnlichkeit zwischen verschiedenen einzelnen Tabellen auswählen, so dass es für jede Kombination aus Bandbreite und binauralen Ähnlichkeit eine eigene Tabelle gibt, die für einen Eingangs-Kanalpegel eine eindeutige Kanalverstärkung liefert.

Eine Alternative hierzu ist in Fig. 3 dargestellt. Hier existiert eine schmalbandige Kanalverstärkungsfunktion 300, die von einem Eingangspegel 310 "angeregt" wird, um einen Verstärkungsfaktor 145 für ein Band zu liefern. Der Eingangspegel 310 wird in Fig. 3 als "zweiter künstlicher Pegel" bezeichnet. Der zweite künstliche Pegel 310 wird folgendermaßen erreicht.

Zunächst wird der tatsächliche Pegel 330 bzw. 130 gemessen und in eine erste Kanalpegelanhebung 320 eingespeist. Die erste Kanalpegelanhebung 320 wird von einer Bandbreite, wie beispielsweise einem SMR-Parameter 210 gesteuert, um für breitbandige Signale eine Kanalpegelanhebung zu erreichen, während für schmalbandige Signale keine Kanalpegelanhebung durchgeführt wird. In anderen Worten durchlaufen relativ schmalbandige Signale bzw. deren Pegel den Block 320 unbeeinflusst, während für breitbandige Signale die tatsächlichen Pegel 330 angehoben werden, um erste künstliche Pegel 340 zu erreichen. Solche künstlichen Pegel 340, die so dimensioniert sind, dass für breitbandige Signale unter Verwendung einer schmalbandig angepassten Kanalverstärkungsfunktion optimale Anpassungen erhalten werden, werden dann in eine zweite Kanalpegelanhebung 350 eingespeist, die von der binauralen Ähnlichkeit 110 gesteuert wird. Wird ein binaurales Signal festgestellt, so wird der erste künstliche Pegel 340 weiter angehoben, um den zweiten künstlichen Pegel 310 zu erhalten, während dann, wenn die binaurale Ähnlichkeit 110 zum Ausdruck bringt, dass das Signal monaural ist, wie beispielsweise in einem Telefonat, die zweite Kanalpegelanhebung 350 ohne Beeinflussung durchlaufen wird, so dass in diesem Fall der zweite künstliche Pegel 310 gleich dem ersten künstlichen Pegel ist.

Alternative Implementierungen von verschiedenen Kanalverstärkungsfunktionen für verschiedene Kombinationen aus Bandbreite/binauralen Ähnlichkeit/Kanalpegel können ebenfalls vorgenommen werden. Der Verstärkungseinsteller 140 ist bei einem Ausführungsbeispiel z. B. ausgebildet, um eine Pegel-Verstärkungswertfunktion 300 zu implementieren, die für monaurale Signale angepasst ist, wobei in Abhängigkeit von der binauralen Ähnlichkeit die Pegelverstärkungswertfunktion bzw. Kanalverstärkungsfunktion oder ein Eingangspegel (40, 350, 310) in die Pegel-Verstärkungswertfunktion 300 modifiziert wird.

Der Verstärkungseinsteller ist hier ausgebildet, um in Abhängigkeit von der binauralen Ähnlichkeit den Eingangspegel gegenüber einem gemessenen Audiosignalpegel des linken oder rechten Kanals zu erhöhen, um im Endeffekt für den gleichen gemessenen Pegel einen kleineren Verstärkungsfaktor zu erhalten.

Bei einem bevorzugten Ausführungsbeispiel wird eine relativ fein aufgelöste Audiosignalanalyse durchgeführt, wobei vorzugsweise eine Pegelanalyse durch den Signalanalysator 120 in sechs oder mehr Bändern durchgeführt wird, und vorzugsweise sogar für alle 24 Bark-Bänder bzw. in den für die Hörhilfe technisch relevanten Bark-Bändern. In dieser Implementierung ist der Verstärkungseinsteller 140 ausgebildet, um für jedes der wenigstens sechs Bänder und für jedes Audiosignal des linken und rechten Audiosignals einen Verstärkungsfaktor zu liefern. Der Kombinationssignalanalysator 100 ist ausgebildet, um den linken Kanal 170 und den rechten Kanal 180 tatsächlich miteinander zu vergleichen bzw. Signaleigenschaften des linken 175 und rechten 185 Kanals wie z.B. deren KurzzeitSpektren miteinander zu vergleichen.

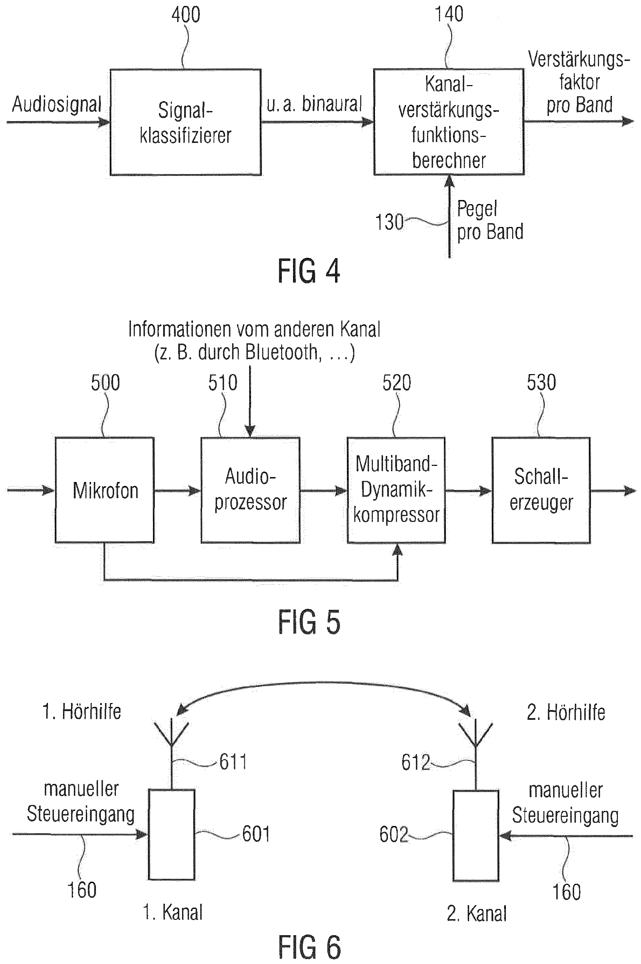

Hierzu wird auf Fig. 6 Bezug genommen, wobei Fig. 6 insbesondere eine Hörhilfe 601 für einen ersten Kanal, wie z.B. ein linkes Ohr, und ferner eine zweite Hörhilfe 602 für einen zweiten Kanal zeigt, wie beispielsweise für das rechte Ohr eines Individuums. Die manuelle Eingabemöglichkeit ist als manueller Steuereingang 160 in Fig. 6 für beide Hörhilfen 601, 602 gezeigt. Alternativ sind auch Antennen 611, 612 dargestellt, um eine Drahtlos-Schnittstelle für die beiden Hörhilfen 601, 602 anzudeuten, über die die beiden Hörhilfen kommunizieren können. Der Kombinationssignalanalysator, der z.B. auf der Basis beider Audiosignale arbeitet, könnte dann entweder in der ersten Hörhilfe 601 für den ersten Kanal oder in der zweiten Hörhilfe 602 für den zweiten Kanal untergebracht sein, um das Ergebnis der binauralen Ähnlichkeit zu dem jeweils anderen Hörgerät zu schicken. Alternativ könnte der Kombinationssignalanalysator in beiden Hörgeräten vorhanden sein. Wieder alternativ könnte der Kombinationssignalanalysator in einem dritten von den beiden Hörhilfen getrennten Gerät untergebracht sein, das dann mit beiden Hörhilfen kommunizieren würde.

Bei einer Ausführung führt der Kombinationssignalanalysator einen spektralen Vergleich durch. Hierzu erhält der Kombinationssignalanalysator ein Spektrum 175 des linken Audiosignals 170 und ein Spektrum 185 des rechten Audiosignals 180 und führt einen Spektralvergleich durch. Der tatsächliche Vergleich kann beispielsweise bandweise vorgenommen werden, um für jedes Band den Pegelunterschied zwischen dem linken und rechten Signal festzustellen, um dann nach Auswertung mehrerer Bänder der Pegelunterschiede zu entscheiden, ob es ein monaurales Signal oder ein binaurales Signal ist, das untersucht worden ist. Eine Möglichkeit könnte beispielsweise sein, dass dann, wenn der Pegel in einem Band um mehr als eine Schwelle, wie beispielsweise 3 dB unterschiedlich ist, eine Unähnlichkeit in dem Band festgestellt wird. Dann werden die (Un-)ähnlichkeitsergebnisse der für das Signal relevanten Bänder ausgewertet, dahin gehend, dass dann, wenn die Mehrheit der Bänder Unähnlichkeitsergebnisse geliefert hat, auf ein monaurales Signal hingewiesen wird. In anderen Worten wäre dann die binaurale Ähnlichkeit so, dass ein monaurales Signal anzeigt, während dann, wenn die Minderheit aller Bänder Unähnlichkeitsergebnisse ergeben hat, die binaurale Ähnlichkeit auf eine binaurale Eigenschaft bzw. binaurale Situation hindeutet.

Der Kombinationssignalanalysator kann ferner ausgebildet sein, um eine gemischte Zeit/Frequenzbereichs-Vergleichsoperation durchzuführen. Die beiden Hörgeräte 601, 602 tauschen hierbei das Bark-Spektrum des aktuellen Signalabschnitts untereinander aus, um anhand des Bark-Spektrums oder zumindest eines Teils des Bark-Spektrums die Binauralität zu bestimmen. Darüber hinaus kann die Bestimmung der Binauralität bandselektiv durchgeführt werden, dahin gehend, dass beispielsweise im unteren Frequenzbereich, der die ersten, beispielsweise acht Bark-Bänder umfasst, eine binaurale Situation festgestellt wird, während im oberen Frequenzbereich oberhalb des beispielsweise achten Bark-Bandes eine monaurale Situation festgestellt wird oder umgekehrt. Entsprechend kann dann jeweils für das entsprechende Band der Verstärkungsfaktor eingestellt werden, um eine möglichst gute Hörgerätesteuerung zu erhalten.

Eine schematische Übersicht über eine Hörhilfe mit einem Mikrofon 500, einem Audioprozessor 510, einem Multiband-Dynamikkompressor 520 und einem Schallerzeuger 530 liefert Fig. 5. Der Audioprozessor 510 ist bei dieser Implementierung ausgebildet, um Informationen von einem anderen Kanal zu erhalten, wie beispielsweise durch Bluetooth oder eine andere Nahfeld-Kommunikation.

Bei bevorzugten Ausführungsbeispielen der vorliegenden Erfindung wird eine bandbreitenabhängigen Steuerung der Verstärkung und eine Steuerung aufgrund der binauralen Ähnlichkeit vorgenommen. Diese Steuerung wird in Echtzeit durchgeführt, um eine optimale Versorgung der Individuen zu erhalten.

Andererseits wird das erfindungsgemäße Konzept auch zur Anpassung verwendet, um eine Anpassung einer Hörhilfe unter Verwendung der unterschiedlichen Vorgehensweisen für schmalbandige und breitbandige Signale und für binaurale und insbesondere für binaurale breitbandige Signale durchzuführen.

Je nach Implementierung kann zum Anpassverfahren eine Verwendung von Lautheitsurteilen aus einer unversorgten oder versorgten Messung genommen werden, oder Lautheitsurteile können aus einem Lautheitsmodell geschätzt werden. Die vorliegende Erfindung führt basierend auf der binauralen Ähnlichkeit eine selektive Verstärkung durch, wobei nicht zwischen schmalbandigen und breitbandigen Signalen unterschieden wird. Es wird jedoch bevorzugt, zusätzlich zur binaurale Ähnlichkeit auch eine Bandbreiten-gesteuerte Verarbeitung und Bestimmung der Verstärkungswerte durchzuführen. Wie gesagt, kann die Anpassung des Dynamikkompressors mit Lautheitsurteilen aus unversorgten oder auch aus versorgten schmal- oder vorzugsweise breitbandigen Messungen durchgeführt werden.

Ein Beispiel, das nicht Teil der Erfindung ist, betrifft ferner einen Algorithmus, der als Regelungsparameter für die Verstärkung einen Parameter benutzt, mit dem Signale in schmalbandig, breitbandig, monaural und binaural klassifiziert werden können, wie es in Fig. 4 dargestellt ist.

Insbesondere wird das Audiosignal einem Signalklassifizierer 400 zugeführt, der ein Klassifikationsergebnis liefert, das unter anderem eine Binauralität bzw. Monauralität umfasst, welche bereits Bezug nehmend auf Kombinationssignalanalysator 100 von Fig. 1 dargelegt worden ist. Die binaurale Ähnlichkeit wird dann dem Kanalverstärkungsfunktionsberechner bzw. Verstärkungseinsteller 140 zugeführt, um dann einen Verstärkungsfaktor bzw. Verstärkungswert pro Band zu liefern, wobei hierzu noch zusätzlich ein Pegel pro Band verwendet wird, wie es auch bei 130 in Fig. 1 dargestellt ist. Eine weitere Signalklassifikation zusätzlich zur Binauralität/Monauralität ist eine Schmalbandigkeit/Breitbandigkeit oder eine weitere Klassifikation, z.B. in Sprachsignale oder Musiksignale, die ebenfalls zusätzlich Verstärkungsfaktoren erfordern können.

Vorzugsweise werden zur Einstellung bzw. Anpassung Testsignale verwendet, die zu den jeweiligen unterschiedlichen Signalklassen gehören, also schmaldbandige/breitbandige, monaurale/binaurale Testsignale.

Insbesondere wird es bevorzugt, Testsignale zu verwenden, die den gleichen Kanalpegel erzeugen, sich aber in ihrer Bandbreite unterscheiden, wie beispielsweise gleichmäßig anregendes Rauschen (UEN; uniform exciting noise) mit einer Mittenfrequenz und verschiedenen Bark-Bandbreiten. Aus dem verarbeiteten Signal kann dann die Verstärkung für die unterschiedlichen Klassen bestimmt werden, so dass unterschiedliche Verstärkungswerte für gleiche Kanalpegel aber unterschiedliche Signalklassen erhalten werden. Vorzugsweise wird der Dynamikkompressor so angepasst, das zunächst die erste Signalklasse bezüglich der Lautheit angepasst wird und dann mit aktivierter Verarbeitung die andere Signalklasse angepasst wird, ohne die Verstärkungswerte für die erste Signalklasse zu ändern.

Ausführungsbeispiele sind anwendbar für die Anpassung von Audio-Dynamikkompressionsalgorithmen an das individuelle Gehör, um den Dynamikbereich eines Schwerhörigen wieder herzustellen. Die Kombination zwischen Anpassvorschrift und Algorithmus kann in Hörgeräten, aber auch in anderen Audioprodukten mit Hörunterstützung, wie beispielsweise Hörhilfen in der Form von Kopfhörern, Headsets etc. eingesetzt werden. Sie bietet mit der Lautheitsskalierung eine Anpassmethode, die im klinischen Alltag eingesetzt werden kann. Auch in Audioprodukten kann eine Abwandlung der Skalierung eingesetzt werden, um die entsprechenden Anpassungen in unkalibrierten Geräten vorzunehmen.

Ein Beispiel, das nicht Teil der Erfindung ist, betrifft ein Verfahren zur Begrenzung des Dynamikbereichs von Audiosignalen, wobei die Dynamikbereichsbegrenzung in Abhängigkeit von einem zum Zeitpunkt der Regelung vorliegenden Regelungsparameter zur Unterscheidung von bestimmten Signalklassen verwendet wird, wobei die Signalklassen eine Monauralität/Binauralität umfassen und gegebenenfalls weitere Signalklassen umfassen, wie beispielsweise schmalbandig und breitbandig, wobei generell mögliche Zwischenstufen zusätzlich zu einer binären Ja/Nein-Entscheidung verwendbar sind.

Nach einer Anpassung des Dynamikkompressors mit Hilfe von Lautheitsurteilen an die erste Signalklasse wird die andere Signalklasse bei aktivierter Versorgung für die erste Signalklasse ermittelt, ohne die Verstärkungswerte für die erste Signalklasse zu verändern. Zur Regelung des Verstärkungsfaktors kann eine automatische Verstärkungsregelung zur Dynamikbegrenzung verwendet werden. Die Begrenzung des Dynamikbereichs kann in mehreren Frequenzkanälen durchgeführt werden, wobei der Regelungsparameter in allen Frequenzkanälen separat berechnet werden oder durch Berechnungsvorschriften über die verschiedenen Frequenzkanäle berechnet werden kann oder aber für alle Frequenzkanäle denselben Wert annehmen kann. Je nach Implementierung wird eine kategoriale Lautheitsskalierung für die Lautheitsurteilsabgabe verwendet. Je nach Implementierung kann die Bandbreite des Signals zusätzlich als Regelungsparameter verwendet werden, und zwar zusätzlich zur Binauralität des Signals als Regelungsparameter. Je nach Implementierung kann auch die Dynamik des Signals selbst als Regelungsparameter verwendet werden, wobei vorzugsweise unterschiedliche Einsatz/Auskling-Zeitkonstanten eingesetzt werden. Eine Lautheitsurteilsabgabe kann bei kontinuierlicher Signalpräsentation kontinuierlich oder nicht kontinuierlich erfolgen. Ferner wird es bevorzugt, die Hörgeräteanpassung im Freifeld vorzunehmen, wobei bei einer weiteren Implementierung eine Hörgeräteanpassung durchgeführt wird, bei der die schmalbandigen monauralen Lautheitsfunktionen über Kopfhörer bestimmt werden und die breitbandige Versorgung im Freifeld mit eingestelltem schmalbandigem Lautheitsausgleich durchgeführt werden.

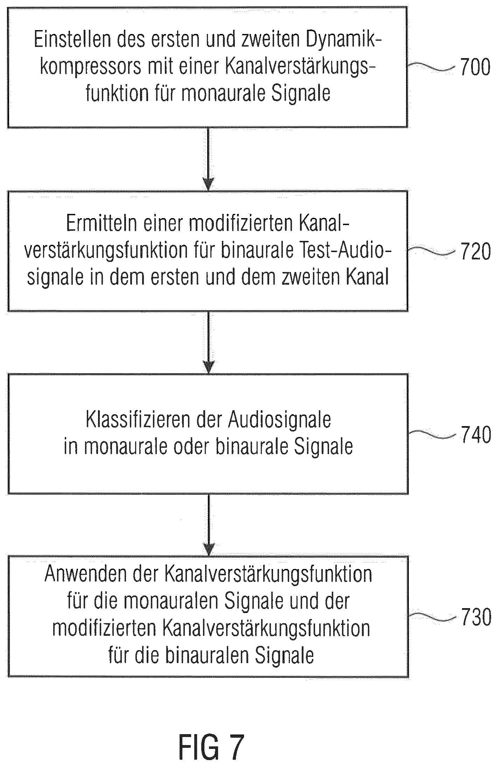

Fig. 7 zeigt ein Blockdiagramm zur Ermittlung von Verstärkungswerten für einen Dynamikkompressor, wie beispielsweise den Multiband-Dynamikkompressor 520 von Fig. 5. In einem Schritt 700 wird der erste Dynamikkompressor und wird ferner auch der zweite Dynamikkompressor für den ersten bzw. den zweiten Kanal mit einer Kanalverstärkungsfunktion für monaurale Audiosignale in dem ersten und dem zweiten Kanal eingestellt. In einem Schritt 720 wird dann eine modifizierte Kanalverstärkungsfunktion für binaurale Test-Audiosignale in dem ersten Kanal und dem zweiten Kanal ermittelt. In einem Schritt 730 werden dann zum einen die Kanalverstärkungsfunktion für monaurale Audiosignale angewendet und ferner die modifizierte Kanalverstärkungsfunktion für binaurale Signale angewendet, und zwar nachdem die Audiosignale in monaurale oder binaurale Signale klassifiziert worden sind, wie es bei 740 in Fig. 7 gezeigt ist.

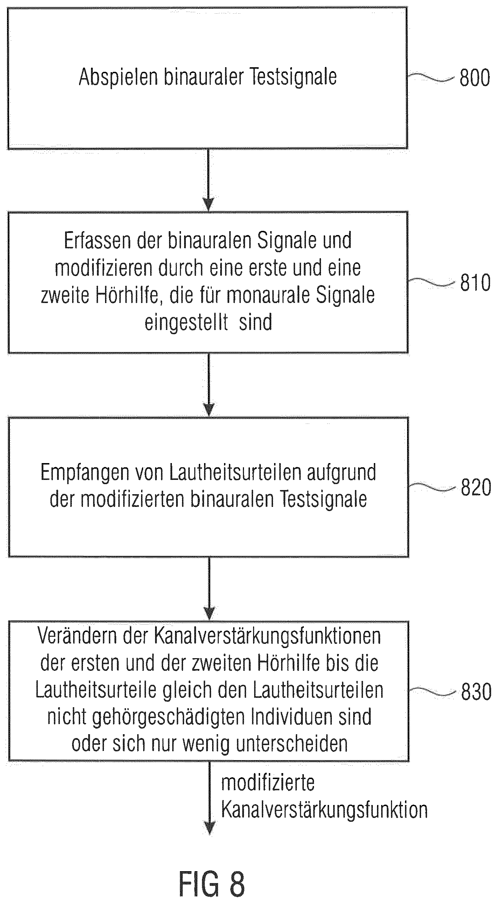

Je nach Implementierung umfasst der Schritt 720 des Ermittelns einer modifizierten Kanalverstärkungsfunktion für binaurale Test-Audiosignale in dem ersten und dem zweiten Kanal Schritte, die in Fig. 8 gezeigt sind. Ein Schritt 800 umfasst das Abspielen binauraler Testsignale für den ersten und den zweiten Kanal. In einem Schritt 810 werden die binauralen Testsignale durch eine erste Hörhilfe für den ersten Kanal einerseits und durch eine zweite Hörhilfe für den zweiten Kanal andererseits erfasst und modifiziert, wobei die erste Hörhilfe und die zweite Hörhilfe bereits für monaurale Signale eingestellt bzw. angepasst sind. In einem Schritt 820 werden dann Lautheitsurteile aufgrund der modifizierten binauralen Testsignale, also der Testsignale, die von den beiden Hörhilfen bereits verarbeitet worden sind, durch eine typischerweise elektrische oder elektronische Vorrichtung empfangen.

Ferner umfasst der Schritt 720 des Ermittelns einer modifizierten Kanalverstärkungsfunktion für binaurale Test-Audiosignale in dem ersten und dem zweiten Kanal den Schritt des Veränderns 830, wieder durch eine typischerweise elektrische oder elektronische Vorrichtung, der Kanalverstärkungsfunktion der ersten und der zweiten Hörhilfe, bis die Lautheitsurteile gleich Lautheitsurteilen von nicht gehörgeschädigten Individuen sind oder sich von diesen nur wenig unterscheiden. Dies kann durch eine rückgekoppelte Regelung mit einer entsprechenden Zielfunktion oder im Vorwärtskopplungsmodus ausgeführt werden. Die modifizierten Kanalverstärkungsfunktionen werden, wieder durch eine typischerweise elektrische oder elektronische Vorrichtung, unter Verwendung der empfangenen Lautheitsurteile derart ermittelt, dass sich bei Anwendung der modifizierten Kanalverstärkungsfunktion in der ersten Hörhilfe und der zweiten Hörhilfe die empfangenen Lautheitsurteile sich von Lautheitsurteilen nicht gehörgeschädigter Individuen um nur wenige dB des Pegels unterscheiden.

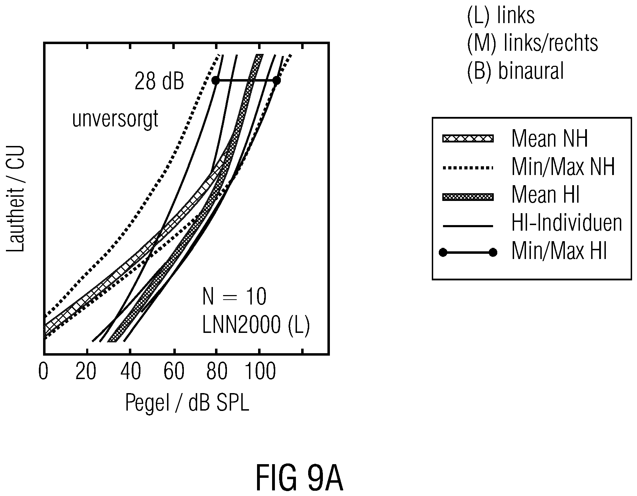

Nachfolgend wird Bezug nehmend auf die Fig. 9a-9c verschiedene Hörtests dargelegt. In jedem Diagramm der Fig. 9a-9c steht entlang der Abszisse der Gesamtpegel des Signals, und zwar in dB SPL, und die Einteilung der Abszisse läuft von 0 bis 100 dB SPL. Entlang der Ordinate ist die Lautheit in CU aufgetragen, wobei CU Kategorie-Einheiten bzw. categorical units sind, also subjektive Lautheitsergebnisse zwischen "sehr leise" (5 CU) und "zu laut" (50 CU). Ferner zeigt in allen Diagrammen die graue dicke Linie Normalhörende, und zwar den mittleren Verlauf Normalhörender (Mean NH) an, während die dicke schwarze Linie den mittleren Verlauf der Hörgeschädigten (Mean HI - mittlerer Verlauf - Hearing Impaired) darstellt. Die dünnen grauen Linien stellen den Verlauf einzelner hörgeschädigter Individuen (HI-Individuen) dar, während der gepunktete Verlauf das Minimum/Maximum von neun gemessenen Normalhörenden darstellt.

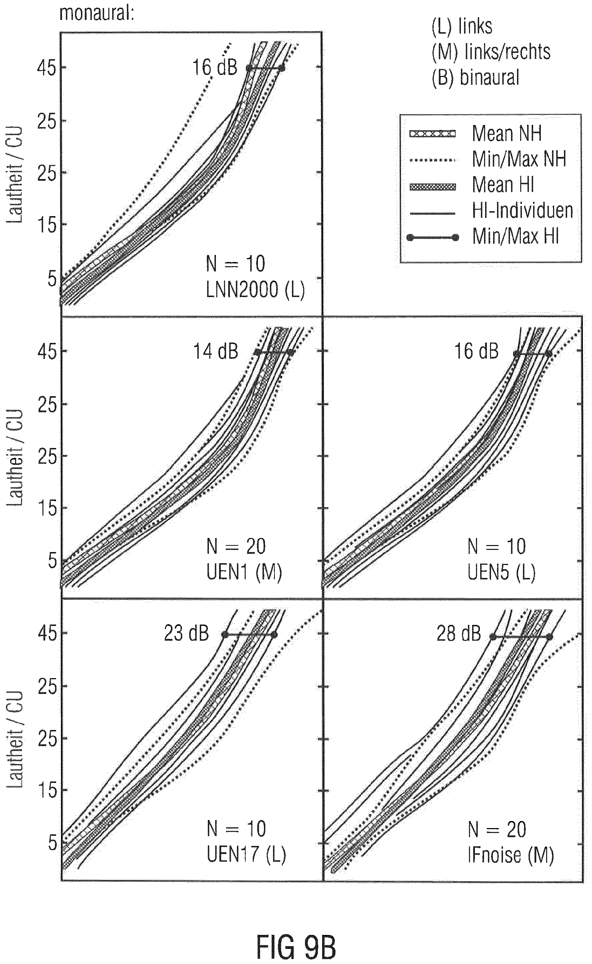

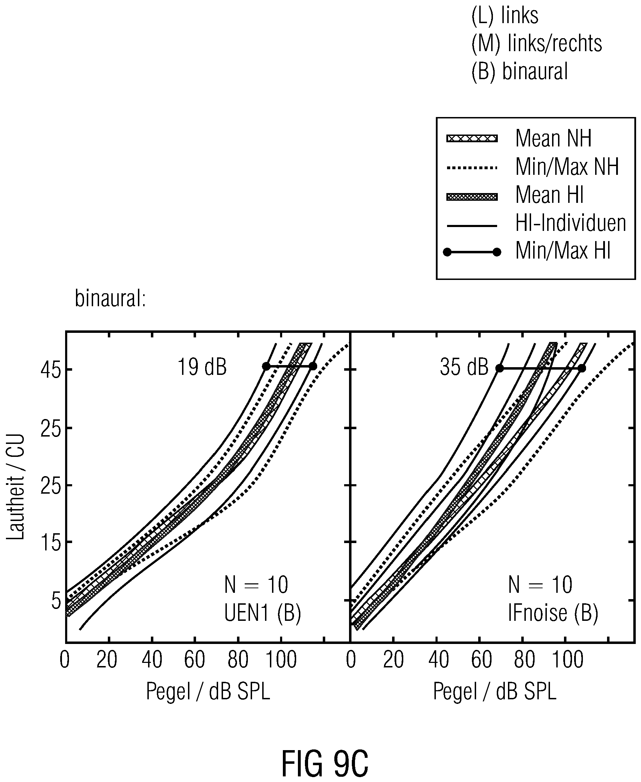

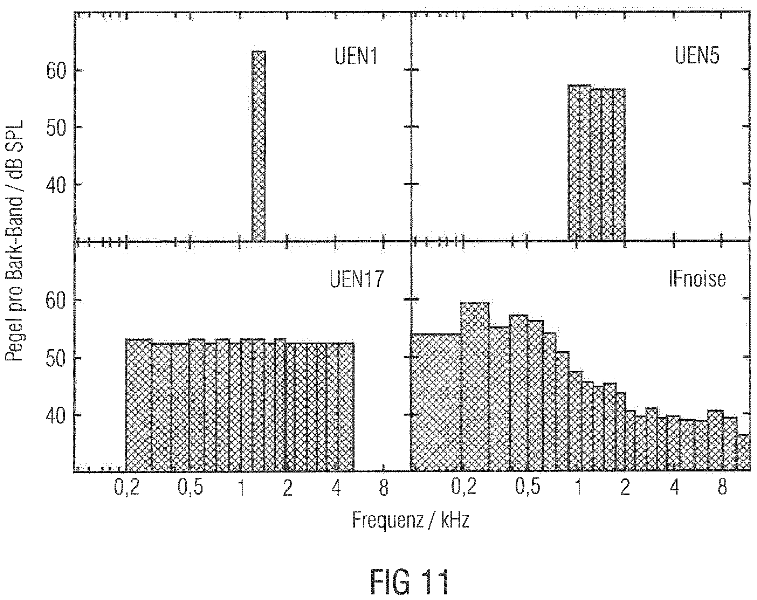

Die zwei Punkte, die durch einen waagerechten Strich verbunden sind, stellen den Unterschied zwischen Minimum und Maximum von Hörgeschädigten (Min/Max HI) bei "sehr laut" (45 CU) dar. Fig. 9b zeigt den Fall, bei dem monaurale stationäre Testsignale verwendet worden sind, und zwar sowohl schmalbandige Signale wie beispielsweise UEN1 als auch breitbandige Signale, wie beispielsweise UEN5, UEN17 oder IFnoise, die insbesondere in Fig. 11 bezüglich ihres Spektrums dargestellt sind. Insbesondere ist bei der Fig. 9b eine Verstärkungsanpassung verwendet worden, bei der die Verstärkungswerte so eingestellt worden sind, dass ein Lautheitsausgleich für schmalbandige Signale erreicht wird. Es zeigt sich eine gute monaurale Anpassung für schmalbandige Signale und insbesondere auch für monaurale breitbandige Signale. Fig. 9c zeigt dagegen Lautheitsurteile für binaurale Testsignale, wobei im linken Fall ein schmalbandiges Testsignal, wie beispielsweise UEN1 verwendet worden ist, während im rechten Fall ein breitbandiges Testsignale, wie beispielsweise IFnoise verwendet worden ist. Es zeigt sich bei schmalbandigen Testsignalen ein Min/Max-Abstand von 19 dB und eine gleichmäßige Verteilung um den mittleren Pegel von den Normalhörenden. Für diesen Fall ist keine, bzw. nur eine geringe Korrektur notwendig. Die Breite der Verteilung für breitbandige Signale steigt auf einen sehr hohen Wert von 35 dB an und ist insbesondere so verschoben, dass der unempfindlichste Hörgeschädigte etwa dem mittleren Normalhörenden entspricht. Dieser Min/Max-Abstand von 35 dB führt dazu, dass ohne die vorliegende Erfindung eine schwerhörige Person Signale um 35 dB zu laut empfindet im Vergleich zu einer normalhörenden Person. Erfindungsgemäß wird daher abhängig von der binauralen Ähnlichkeit eine Reduktion der Verstärkungsfaktoren bzw. bei der Implementierung, wie sie in Fig. 3 dargestellt worden ist, eine künstliche Pegelanhebung auf die zweiten künstlichen Pegel 310 vorgenommen, um im Endeffekt eine geringere Verstärkung für Signale mit hohem Pegel, insbesondere für breitbandige Signale im binauralen Fall zu erhalten. Die Verstärkungsfaktoren werden derart angepasst, dass der Abstand Min/Max HI im rechten Bild von Fig. 9c so klein wie möglich wird, wie beispielsweise in der Größenordnung von lediglich 20 dB oder besser noch viel weniger und die Verteilung gleichverteilt um den mittleren Pegel von Normalhörenden ist.

Wie gesagt, sind individuelle Lautheitsfunktionen für HI-Hörer als dünne graue Linien in Fig. 9a-9c gezeigt. Der Pegel auf der x-Achse entspricht dem Eingangspegel in dem Dynamikkompressionsalgorithmus. Die NH-Lautheitsfunktionen sind durch die dicke graue Linie (Mittelwert) und die gestrichelten grauen Linien (Minimum- und Maximumwerte) dargestellt. Die dicke schwarze Linie zeigt die mittlere Lautheitsfunktion der HI-Hörer.

Fig. 9a zeigt die Situation für ein schmalbandiges monaurales LNN2000-Signal ohne Lautheitskompensation, also unversorgt. Wie erwartet, bewirken die erhöhten Hörschwellen der HI-Hörer eine Rechtsverschiebung der Lautheitsfunktionen in den Bereichen niedriger Lautheit. Das Ergebnis der Verstärkung des LNN2000-Signals gemäß der Schmalband-Lautheitskompensationsstrategie, wie es in Fig. 9b oben links gezeigt ist, resultiert in individuellen Lautheitsfunktionen (dünnen grauen Linien), die nahe der mittleren NH-Lautheitsfunktion (dicke graue Linien) sind. Die mittlere kompensierte HI-Lautheitsfunktion (dicke schwarze Linie) stimmt mit dem NH-Ziel (dicke graue Linie) gut überein. Ähnliche Resultate findet man für das schmalbandige UEN1-Signal in dem monauralen (N) und in dem binauralen (B) Fall. Für die monauralen Breitbandsignale (UEN5, UEN17 und IFnoise), wird eine gute Übereinstimmung zwischen der Ziel-NH-Lautheitsfunktion und der mittleren kompensierten HI-Lautheitsfunktion betrachtet. Für das IFnoise-Signal in binauraler Bedingung (Fig. 9c rechts) zeigen die HI-Hörer eine durchschnittliche Lautheitsfunktion mit einer steileren Steigung über 20 CU. Hier wurden dieselben Lautheiten bei niedrigeren Pegeln im Vergleich zu dem mittleren NH-Hörer erreicht. Dies zeigt eine höhere Empfindlichkeit bei HI-Hörern für das breitbandige IFnoise-Signal in der binauralen Situation mit einem Abstand von 14,1 dB zwischen den Mittelwerten beider Gruppen bei 45 CU.

Um diese erhöhte Empfindlichkeit zu reduzieren, werden die Kanalverstärkungsfaktoren bei Vorliegen einer binauralen Bedingung abgesenkt.

Bei Ausführungsbeispielen der vorliegenden Erfindung sind die erforderlichen Korrekturwerte für die bandselektive Verstärkung so, dass die normale Lautheitswahrnehmung wieder hergestellt wird. Insbesondere wird erfindungsgemäß die binaurale Lautheitssummation berücksichtigt, die, wie die Erfinder herausgefunden haben, die Lautheitswahrnehmung signifikant beeinträchtigt. Um eine gleiche Lautheitswahrnehmung zu erreichen, benötigen Signale, die einem Ohr geliefert werden, höhere Werte im Vergleich zu einer Situation, bei dem diese Signale beiden Ohren präsentiert werden. Dieser binaurale Lautheitssummationseffekt für Normalhörende ist stärker für breitbandige Signale im Vergleich zu schmalbandigen Signalen. Dieser Effekt ist offenbar ähnlich für Hörgeschädigte für schmalbandige Signale aber deutlich erhöht für breitbandige Signale. Die vorliegende Erfindung schafft ein Verfahren, um die benötigte Verstärkungsreduktion für breitbandige Signale im Anschluss an eine Schmalbandkompensation zu bestimmen. Ferner ermöglicht die vorliegende Erfindung, dass diese Verstärkungsreduktionsfaktoren unabhängig von einer Schmalbandkompensation zusätzlich zur Schmalbandkompensation angewendet werden können.

Ein Ausführungsbeispiel der vorliegenden Erfindung nutzt als Ziellautheitsfunktion die mittleren Lautheitsfunktionen von Normalhörenden, um entsprechende Verstärkungswerte für schmalbandige, breitbandige, monaurale und binaurale Signale zu ermitteln. Dabei können die Ziellautheitsfunktionen auch anders ermittelt oder vorgegeben werden, z.B. können die Lautheitsfunktionen genutzt werden, die bei dem gegenüber Lautheit unempfindlichsten Normalhörenden gemessen worden sind, oder es können die Lautheitsfunktionen in ihrer Lage und Form vorgegeben werden, um z.B. zu verhindern, dass es überhaupt zu Lautheitsurteilen oberhalb von "laut" kommt.

Fig. 11 zeigt verschiedene Testsignale, wobei ein schmalbandiges Testsignal UEN1 gezeigt ist, das lediglich ein einziges Bark-Band besetzt, während ein erstes relativ wenig breitbandiges Signal UEN5 gezeigt ist, das fünf Bark-Bänder besetzt. Ein noch breitbandigeres Signal UEN17 besetzt 17 Bark-Bänder und das breitbandigste Signal IFnoise, das ein Spektrum hat, das dem Spektrum von Sprache stark ähnelt, besetzt die gesamte Bandbreite, also 24 Bark-Bänder. Insbesondere wurde bei den gezeigten Signalen die Energie der UEN-Signale gleichmäßig über die Bark-Bänder verteilt, so dass die einzelne Energie in den Bändern des UEN17-Signals zusammen die Energie im einzigen Band des UEN1-Signals ergeben. Ferner ist die Energie in allen UEN5-Bändern zusammen gleich der Energie in allen UEN17-Bändern oder dem einzigen UEN1-Band. Das Signal IFnoise ähnelt dem Langzeitdurchschnitts-Sprachspektrum für weibliche Sprecher und zeigt ein abnehmendes Bark-Spektrum.

Bei der Berechnung der binauralen Ähnlichkeit sollten nur Bänder berücksichtigt werden, die für das Signal wesentlich sind. Beispielsweise wird das Signal UEN1 mit einem hohen Pegel (beispielsweise 70 dB SPL auf linken und rechtem Ohr) mit dem UEN17 mit einem niedrigen Pegel gemischt. Der Pegel des UEN17 unterscheidet sich auf dem linken und rechten Ohr also beispielsweise links 30 dB und rechts 20 dB. Dann würde ein Vergleich der Bänder dazu führen, dass in allen Bändern ein Unterschied von 10 dB vorliegt, außer in dem Band des UEN1, wo ein Unterschied von 0 dB vorliegt. Da das UEN1 aber deutlich lauter wahrgenommen wird, als das UEN17, ist nur das Band des UEN1 für den Lautheitseindruck von wesentlicher Bedeutung, weshalb eine hohe binaurale Ähnlichkeit für das Signal ermittelt wird. Alternativ könnte die binaurale Ähnlichkeit für jedes Band verarbeitet werden, so dass das Band des UEN1 eine hohe binaurale Ähnlichkeit aufweist, alle anderen Bänder aber eine niedrige binaurale Ähnlichkeit zeigen.

Erfindungsgemäß wird sichergestellt, dass Hörgeschädigte, selbst wenn sie mit einer monauralen Schmalbandlautheitskompensationsstrategie versorgt sind, keine höheren Lautheitsurteile abgeben, da für insbesondere breitbandige binaurale Signale die Verstärkungsfaktoren reduziert werden. Damit wird berücksichtigt, dass es bei Gehörgeschädigten ebenfalls den Effekt der spektralen Lautheitssummation und der binauralen Lautheitssummation gibt. Ferner wird der Komfort der Hörgeschädigten stark erhöht, wenn bereits für die Diagnose der Hörschädigung und insbesondere auch für die Einstellung der Hörhilfe-Breitbandsignale mit binauraler Präsentation eingesetzt werden.

### Literatur

[1] O, Strlcyk u. a., "Restoration of loudness summation and differential loudness growth in hearing-impaired listeners", The Journal of the Acoustical Society of America, vol. 132, no. 4, pp. 2557-2568, Oktober 2012
[2] D. Oetting u.a., "Model-based loudness compensation for broad- and narrow-band signals", Proceedings of ISAAR 2013; Auditory plasticity - Listening with the brain, 2013
[3] Z. Chen, u.a., "CHENFIT-AMP, A nonlinear Fitting and Amplification Strategy for Cochlear Hearing Loss", IEEE Transactions on Bio-medical Engineering, pp. 326-3237, Juli 2013
[4] J. Kiessling, u.a., "Adaptive fitting of hearing instruments by category loudness scaling (ScalAdapt)", International Journal of Audiology, vol. 25, no. 3, pp. 153-160, 1996
[5] T. Brand, "Loudness Scaling", 8th EFAS Congress/10th Congress of the German Society of Audiology, Heidelberg: Deutsche Gesellschaft für Audiologie e. V. 2007, pp. CD-ROM

## Patentansprüche

1. Vorrichtung zum Ansteuern eines ersten Dynamikkompressors (520) in einer ersten rechten Hörhilfe (602) mit jeweils einem ersten Verstärkungswert (145) pro Band einer Mehrzahl von Frequenzbändern und eines zweiten Dynamikkompressors in einer zweiten linken Hörhilfe (601) mit jeweils einem zweiten Verstärkungswert pro Band einer Mehrzahl von Frequenzbändern, mit folgenden Merkmalen:
einem Kombinationssignalanalysator (100) zum Feststellen einer binauralen Ähnlichkeit (110) zwischen einem rechten Audiosignal (180) und einem linken Audiosignal (170); und
einem Verstärkungseinsteller (140) zum Liefern des jeweils ersten Verstärkungswerts (145) für ein Band des rechten Audiosignals (180) in Abhängigkeit von der binauralen Ähnlichkeit (110) und einem Pegel des rechten Audiosignals (180) in dem Band und zum Liefern des jeweils zweiten Verstärkungswerts für ein Band des linken Audiosignals (170) in Abhängigkeit von der binauralen Ähnlichkeit (110) und einem Pegel des linken Audiosignals (170) in dem Band, **dadurch gekennzeichnet, dass** der Verstärkungseinsteller (140) ausgebildet ist, um den ersten Verstärkungswert (145) für den ersten Dynamikkompressor (520) bei gleichem Pegel des rechten Audiosignals (180) und hoher binauraler Ähnlichkeit (110) auf einen kleineren Wert einzustellen, als bei einer geringen binauralen Ähnlichkeit (110), und um den zweiten Verstärkungswert für den zweiten Dynamikkompressor bei gleichem Pegel des linken Audiosignals (170) und hoher binauraler Ähnlichkeit (110) auf einen kleineren Wert einzustellen, als bei einer geringen binauralen Ähnlichkeit (110).

2. Vorrichtung nach Anspruch 1, die ferner einen Signal-Analysator (120) aufweist, um das rechte Audiosignal (180) und das linke Audiosignal (170) in die Mehrzahl von Bändern zu zerlegen, und um in jedem Band der Mehrzahl von Bändern einen Pegel zu ermitteln, wobei der Verstärkungseinsteller (140) ausgebildet ist, um für jedes Band des rechten Audiosignals (180) den jeweils ersten Verstärkungswert (145) in Abhängigkeit von der binauralen Ähnlichkeit (110) und dem Pegel des rechten Audiosignals (180) in dem Band zu liefern, und um für jedes Band des linken Audiosignals (170) den jeweils zweiten Verstärkungswert in Abhängigkeit von der binauralen Ähnlichkeit (110) und dem Pegel des linken Audiosignals (170) in dem Band zu liefern,.

3. Vorrichtung nach einem der vorhergehenden Ansprüche,
bei der der Kombinationssignalanalysator (100) ferner ausgebildet ist, um eine Bandbreite (210) des rechten Audiosignals (180) und des linken Audiosignals (170) oder eine Bandbreite (210) einer Kombination des rechten Audiosignals (180) und des linken Audiosignals (170) zu ermitteln, und
bei der der Verstärkungseinsteller (140) ausgebildet ist, um den jeweils ersten Verstärkungswert und den jeweils zweiten Verstärkungswert für ein Band der Mehrzahl von Bändern ferner in Abhängigkeit von der ermittelten Bandbreite (210) einzustellen (155).

4. Vorrichtung nach Anspruch 3,
bei der der Verstärkungseinsteller (140) ausgebildet ist, um den jeweils ersten Verstärkungswert (145) bei gleichem Pegel des rechten Audiosignals (180) und hoher Bandbreite (210) auf einen kleineren Wert einzustellen als bei einer geringen Bandbreite (210), und bei der der Verstärkungseinsteller (140) ausgebildet ist, um den jeweils zweiten Verstärkungswert bei gleichem Pegel des linken Audiosignals (170) und hoher Bandbreite (210) auf einen kleineren Wert einzustellen als bei einer geringen Bandbreite (210).

5. Vorrichtung nach einem der vorhergehenden Ansprüche,
bei der der Verstärkungseinsteller (140) ausgebildet ist, um eine Pegel-Verstärkungswertfunktion (200, 300) zu implementieren, die für monaurale Signale angepasst ist, und
wobei der Verstärkungseinsteller (140) ausgebildet ist, um abhängig von der binauralen Ähnlichkeit (110) die Pegel-Verstärkungswert-Funktion oder einen Eingangspegel in die Pegel-Verstärkungswert-Funktion zu modifizieren.

6. Vorrichtung nach Anspruch 5,
bei der der Verstärkungseinsteller (140) ausgebildet ist, um abhängig von der binauralen Ähnlichkeit (110) den Eingangspegel gegenüber einem gemessenen Audiosignalpegel zu erhöhen (350).

7. Vorrichtung nach Anspruch 2, bei der der Signalanalysator (120) ausgebildet ist, um das rechte Audiosignal (180) und das linke Audiosignal (170) in wenigstens 6 Bänder zu zerlegen,
wobei der Verstärkungseinsteller (140) ausgebildet ist, um für jedes der wenigstens 6 Bänder des rechten Audiosignals (180) den jeweils ersten Verstärkungswert (145) zu liefern, und um für jedes der wenigstens 6 Bänder des linken Audiosignals (170) den jeweils zweiten Verstärkungswert zu liefern.

8. Vorrichtung nach einem der vorhergehenden Ansprüche,
bei der der Kombinationssignalanalysator (100) ausgebildet ist, um ein Spektrum des rechten Audiosignals (180) und ein Spektrum des linken Audiosignals (170) zu erhalten und um die binaurale Ähnlichkeit (110) durch einen Vergleich der beiden Spektren zu ermitteln.

9. Vorrichtung nach einem der vorhergehenden Ansprüche,
bei der der Kombinationssignalanalysator (100) ausgebildet ist, um Pegel in der Mehrzahl von Bändern des rechten Audiosignals (180) und des linken Audiosignals (170) zu vergleichen und durch eine Auswertung von für das rechte Audiosignal (180) und das linke Audiosignal (170) wesentlichen Bändern eine binaurale Ähnlichkeit (110) des rechten Audiosignals (180) und des linken Audiosignals (170) zu liefern, wobei die für das rechte Audiosignal (180) oder das linke Audiosignal (170) wesentlichen Bänder die Bänder sind, die einen Lautheitsanteil am gesamten rechten Audiosignal (180) oder am gesamten linken Audiosignal (170) von mehr als 1 Prozent aufweisen.

10. Vorrichtung nach Anspruch 8,
bei der der Kombinationssignalanalysator (100) ausgebildet ist, um eine Energiedifferenz einander entsprechender Bänder der Spektren des rechten Audiosignals (180) und des linken Audiosignals (170) zu ermitteln, und wobei ein Mittelwert der Energiedifferenzen über die für das rechte Audiosignal (180) bzw. das linke Audiosignal (170) wesentlichen Bänder einen Wert für die binaurale Ähnlichkeit (110)des rechten Audiosignals (180) und des linken Audiosignals (170) darstellt, wobei die für das rechte Audiosignal (180) oder das linke Audiosignal (170) wesentlichen Bänder die Bänder sind, die einen Lautheitsanteil am gesamten rechten Audiosignal (180) oder am gesamten linken Audiosignal (170) von mehr als 1 Prozent aufweisen.

11. Verfahren zum Ansteuern eines ersten Dynamikkompressors (520) in einer ersten rechten Hörhilfe (602) mit einem ersten Verstärkungswert (145) und eines zweiten Dynamikkompressors in einer zweiten linken Hörhilfe (601) mit einem zweiten Verstärkungswert, mit folgenden Schritten:
Feststellen (100) einer binauralen Ähnlichkeit (110) zwischen einem rechten Audiosignal (180) und einem linken Audiosignal (170);
Liefern (140) des ersten Verstärkungswerts (145) für ein Band des rechten Audiosignals (180) in Abhängigkeit von der binauralen Ähnlichkeit (110) und einem Pegel des rechten Audiosignals (180) in dem Band; und
Liefern des zweiten Verstärkungswerts für ein Band des linken Audiosignals (170) in Abhängigkeit von der binauralen Ähnlichkeit (110) und einem Pegel des linken Audiosignals (170) in dem Band,
wobei der erste Verstärkungswert für den ersten Dynamikkompressor bei gleichem Pegel des rechten Audiosignals (180) und hoher binauraler Ähnlichkeit (110) auf einen kleineren Wert eingestellt wird, als bei einer geringen binauralen Ähnlichkeit (110), und wobei der zweite Verstärkungswert für den zweiten Dynamikkompressor bei gleichem Pegel des linken Audiosignals (170) und hoher binauraler Ähnlichkeit (110) auf einen kleineren Wert eingestellt wird, als bei einer geringen binauralen Ähnlichkeit (110).

12. Computerprogramm mit einem Programmcode zum Ausführen des Verfahrens gemäß Anspruch 11, wenn das Computerprogramm auf einem Computer abläuft.

## Claims

1. Apparatus for controlling a first dynamic compressor (520) in a first right hearing aid (602) with a first amplification value (145) per band of a plurality of frequency bands and a second dynamic compressor in a second left hearing aid (601) with a respective second amplification value per band of a plurality of frequency bands, comprising:
a combination signal analyzer (100) for determining a binaural similarity (110) between a right audio signal (180) and a left audio signal (170); and
an amplification adjuster (140) for providing the respective first amplification value (145) for a band of the right audio signal (180) in dependence on the binaural similarity (110) and a level of the right audio signal (180) in the band and for providing the respective second amplification value for a band of the left audio signal (170) in dependence on the binaural similarity (110) and a level of the left audio signal (170) in the band,
**characterized in that**
the amplification adjuster (140) is configured to adjust the first amplification value (145) for the first dynamic compressor (520), at the same level of the right audio signal (180) and with high binaural similarity (110), to a smaller value than in the case of low binaural similarity (110), and to adjust the second amplification value for the second dynamic compressor, at the same level of the left audio signal (170) and with high binaural similarity (110), to a smaller value than in the case of low binaural similarity (110).

2. Apparatus according to claim 1, further comprising a signal analyzer (120) for splitting the right audio signal (180) and the left audio signal (170) into the plurality of bands and for determining a level in each band of the plurality of bands, wherein the amplification adjuster (140) is configured to provide, for each band of the right audio signal (180), the respective first amplification value (145) in dependence on the binaural similarity (110) and the level of the right audio signal (180) in the band, and to provide, for each band of the left audio signal (170), the respective second amplification value in dependence on the binaural similarity (110) and the level of the left audio signal (170) in the band.

3. Apparatus according to any one of the preceding claims,
wherein the combination signal analyzer (100) is further configured to determine a bandwidth (210) of the right audio signal (180) and the left audio signal (170) or a bandwidth (210) of a combination of the right audio signal (180) and the left audio signal (170), and
wherein the amplification adjuster (140) is configured to further adjust (155) the respective first amplification value and the respective second amplification value for a band of the plurality of bands in dependence on the determined bandwidth (210).

4. Apparatus according to claim 3,
wherein the amplification adjuster (140) is configured to adjust the respective first amplification value (145), at the same level of the right audio signal (180) and with high bandwidth (210), to a smaller value than in the case of a low bandwidth (210), and wherein the amplification adjuster (140) is configured to adjust the respective second amplification value, at the same level of the left audio signal (170) and with high bandwidth (210), to a smaller value than in the case of a low bandwidth (210).

5. Apparatus according to any one of the preceding claims,
wherein the amplification adjuster (140) is configured to implement a level amplification value function (200, 300) that is adapted for monaural signals, and
wherein the amplification adjuster (140) is configured to modify, depending on the binaural similarity (110), the level amplification value function or an input level in the level amplification value function.

6. Apparatus according to claim 5,
wherein the amplification adjuster (140) is configured to increase (350), in dependence on the binaural similarity (110), the input level with respect to a measured audio signal level.

7. Apparatus according to claim 2, wherein the signal analyzer (120) is configured to split the right audio signal (180) and the left audio signal (170) into at least six bands,
wherein the amplification adjuster (140) is configured to provide, for each of the at least six bands of the right audio signal (180), the respective first amplification value (145) and to provide, for each of the at least six bands of the left audio signal (170), the respective second amplification value.

8. Apparatus according to any one of the preceding claims,
wherein the combination signal analyzer (100) is configured to acquire a spectrum of the right audio signal (180) and a spectrum of the left audio signal (170) and to determine the binaural similarity (110) by comparing the two spectra.

9. Apparatus according to any one of the preceding claims,
wherein the combination signal analyzer (100) is configured to compare levels in the plurality of bands of the right audio signal (180) and the left audio signal (170) and to provide, by evaluating bands essential for the right audio signal (180) and the left audio signal (170), a binaural similarity (110) of the right audio signal (180) and the left audio signal (170), wherein the bands essential for the right audio signal (180) or the left audio signal (170) are those bands that comprise a loudness proportion of the entire right audio signal (180) or the entire left audio signal (170) of more than 1 percent.

10. Apparatus according to claim 8,
wherein the combination signal analyzer (100) is configured to determine an energy difference of corresponding bands of the spectra of the right audio signal (180) and the left audio signal (170), and wherein an average value of the energy differences across the bands essential for the right audio signal (180) and the left audio signal (170), respectively, represents a value for the binaural similarity (110) of the right audio signal (180) and the left audio signal (170), wherein the bands essential for the right audio signal (180) or the left audio signal (170) are those bands that comprise a loudness proportion of the entire right audio signal (180) or the entire left audio signal (170) of more than 1 percent.

11. Method for controlling a first dynamic compressor (520) in a first right hearing aid (602) with a first amplification value (145) and a second dynamic compressor in a second left hearing aid (601) with a second amplification value, comprising:
determining (100) a binaural similarity (110) between a right audio signal (180) and a left audio signal (170); and
providing (140) a first amplification value (145) for a band of the right audio signal (180) in dependence on the binaural similarity (110) and a level of the right audio signal (180) in the band; and
providing the second amplification value for a band of the left audio signal (170) in dependence on the binaural similarity (110) and a level of the left audio signal (170) in the band,
wherein the first amplification value for the first dynamic compressor is adjusted, at the same level of the right audio signal (180) and with high binaural similarity (110), to a smaller value than in the case of low binaural similarity (110), and wherein the second amplification value for the second dynamic compressor is adjusted, at the same level of the left audio signal (170) and with high binaural similarity (110), to a smaller value than in the case of low binaural similarity (110).

12. Computer program having a program code for performing the method of claim 11 when the computer program runs on a computer.

## Revendications

1. Dispositif de commande d'un premier compresseur dynamique (520) dans une première prothèse auditive droite (602) avec chaque fois une première valeur de gain (145) par bande d'une pluralité de bandes de fréquences et d'un deuxième compresseur dynamique dans une deuxième prothèse auditive gauche (601) avec chaque fois une deuxième valeur de gain par bande d'une pluralité de bandes de fréquences, aux caractéristiques suivantes:
un analyseur de signal de combinaison (100) destiné à déterminer une similitude binaurale (110) entre un signal audio droit (180) et un signal audio gauche (170); et
un moyen de réglage de gain (140) destiné à fournir la première valeur de gain respective (145) pour une bande du signal audio droit (180) en fonction de la similitude binaurale (110) et d'un niveau du signal audio droit (180) dans la bande et à fournir la deuxième valeur de gain pour une bande du signal audio gauche (170) en fonction de la similitude binaurale (110) et d'un niveau du signal audio gauche (170) dans la bande,
**caractérisé par le fait que**
le moyen de réglage de gain (140) est conçu pour régler la première valeur de gain (145) pour le premier compresseur dynamique (520), à un même niveau du signal audio droit (180) et à haute similitude binaurale (110), à une valeur inférieure qu'en cas de faible similitude binaurale (110), et pour régler la deuxième valeur de gain pour le deuxième compresseur dynamique, à un même niveau du signal audio gauche (170) et à haute similitude binaurale (110), à une valeur inférieure qu'en cas de faible similitude binaurale (110).

2. Dispositif selon la revendication 1, qui présente par ailleurs un analyseur de signal (120) pour décomposer le signal audio droit (180) et le signal audio gauche (170) en la pluralité de bandes et pour déterminer, dans chaque bande de la pluralité de bandes, un niveau, dans lequel le moyen de réglage de gain (140) est conçu pour fournir, pour chaque bande du signal audio droit (180), la première valeur de gain (145) respective en fonction de la similitude binaurale (110) et du niveau du signal audio droit (180) dans la bande, et pour fournir, pour chaque bande du signal audio gauche (170), la deuxième valeur de gain respective en fonction de la similitude binaurale (110) et du niveau du signal audio gauche (170) dans la bande.

3. Dispositif selon l'une des revendications précédentes,
dans lequel l'analyseur de signal de combinaison (100) est par ailleurs conçu pour déterminer une largeur de bande (210) du signal audio droit (180) et du signal audio gauche (170) ou une largeur de bande (210) d'une combinaison du signal audio droit (180) et du signal audio gauche (170), et
dans lequel le moyen de réglage de gain (140) est conçu pour régler (155) la première valeur de gain respective et la deuxième valeur de gain respective pour une bande de la pluralité de bandes en fonction de la largeur de bande déterminée (210).

4. Dispositif selon la revendication 3,
dans lequel le moyen de réglage de gain (140) est conçu pour régler la première valeur de gain respective (145), à un même niveau du signal audio droit (180) et à grande largeur de bande (210), à une valeur inférieure qu'en cas d'une largeur de bande (210) inférieure, et dans lequel le moyen de réglage de gain (140) est conçu pour régler la deuxième valeur de gain respective, à un même niveau du signal audio gauche (170) et à grande largeur de bande (210), à une valeur inférieure qu'en cas d'une largeur de bande (210) inférieure.

5. Dispositif selon l'une des revendications précédentes,
dans lequel le moyen de réglage de gain (140) est conçu pour mettre en œuvre une fonction de valeur de gain de niveau (200, 300) qui est adaptée pour des signaux monauraux, et
dans lequel le moyen de réglage de gain (140) est conçu pour modifier, en fonction de la similitude binaurale (110), la fonction de valeur de gain de niveau ou un niveau d'entrée dans la fonction de valeur de gain de niveau.

6. Dispositif selon la revendication 5,
dans lequel le moyen de réglage de gain (140) est conçu pour augmenter (350), en fonction de la similitude binaurale (110), le niveau d'entrée par rapport à un niveau de signal audio mesuré.

7. Dispositif selon la revendication 2, dans lequel l'analyseur de signal (120) est conçu pour décomposer le signal audio droit (180) et le signal audio gauche (170) en au moins 6 bandes,
dans lequel le moyen de réglage de gain (140) est conçu pour fournir, pour chacune des au moins 6 bandes du signal audio droit (180), la première valeur de gain respective (145) et pour fournir, pour chacune des au moins 6 bandes du signal audio gauche (170), la deuxième valeur de gain respective.

8. Dispositif selon l'une des revendications précédentes,
dans lequel l'analyseur de signal de combinaison (100) est conçu pour obtenir un spectre du signal audio droit (180) et un spectre du signal audio gauche (170) et pour déterminer la similitude binaurale (110) par une comparaison des deux spectres.

9. Dispositif selon l'une des revendications précédentes,
dans lequel l'analyseur de signal de combinaison (100) est conçu pour comparer les niveaux dans la pluralité de bandes du signal audio droit (180) et du signal audio gauche (170) et pour fournir, par une évaluation des bandes essentielles pour le signal audio droit (180) et le signal audio gauche (170), une similitude binaurale (110) entre le signal audio droit (180) et le signal audio gauche (170), où les bandes essentielles pour le signal audio droit (180) ou le signal audio gauche (170) sont les bandes qui présentent une part de volume sonore dans l'ensemble du signal audio droit (180) ou dans l'ensemble du signal audio gauche (170) de plus de 1 pour cent.

10. Dispositif selon la revendication 8,
dans lequel l'analyseur de signal de combinaison (100) est conçu pour déterminer une différence d'énergie entre les bandes correspondant entre elles des spectres du signal audio droit (180) et du signal audio gauche (170), et dans lequel une valeur moyenne des différences d'énergie sur les bandes essentielles pour le signal audio droit (180) et le signal audio gauche (170) représente une valeur pour la similitude binaurale (110) du signal audio droit (180) et du signal audio gauche (170), dans lequel les bandes essentielles pour le signal audio droit (180) ou le signal audio gauche (170) sont les bandes qui présentent une part de volume sonore dans l'ensemble du signal audio droit (180) ou dans l'ensemble du signal audio gauche (170) de plus de 1 pour cent.

11. Procédé de commande d'un premier compresseur dynamique (520) dans une première prothèse auditive droite (602) avec une première valeur de gain (145) et d'un deuxième compresseur dynamique dans une deuxième prothèse auditive gauche (601) avec une deuxième valeur de gain, aux étapes suivantes consistant à:
déterminer (100) une similitude binaurale (110) entre un signal audio droit (180) et un signal audio gauche (170);
fournir (140) la première valeur de gain (145) pour une bande du signal audio droit (180) en fonction de la similitude binaurale (110) et d'un niveau du signal audio droit (180) dans la bande; et
fournir la deuxième valeur de gain pour une bande du signal audio gauche (170) en fonction de la similitude binaurale (110) et d'un niveau du signal audio gauche (170) dans la bande,
dans lequel la première valeur de gain est réglée pour le premier compresseur dynamique, à un même niveau du signal audio droit (180) et à haute similitude binaurale (110), à une valeur inférieure qu'en cas d'une faible similitude binaurale (110), et dans lequel la deuxième valeur de gain est réglée pour le deuxième compresseur dynamique, à un même niveau du signal audio gauche (170) et à haute similitude binaurale (110), à une valeur inférieure qu'en cas d'une faible similitude binaurale (110).

12. Programme d'ordinateur avec un code de programme pour réaliser le procédé selon la revendication 11 lorsque le programme d'ordinateur est exécuté sur un ordinateur.
